# EUROPEAN PATENT APPLICATION

(11) **EP 4 692 943 A1**
(43) Date of publication of application: **11.02.2026**
(21) Application number: 24780340.6
(22) Date of filing: 26.03.2024
(51) Int. Cl.: G03F 7/11, G03F 7/20, G03F 7/26, G03F 7/40, G03F 7/42

(54) **RESIST UNDERLAYER FILM FORMING COMPOSITION**

(30) Priority: 27.03.2023 JP 2023050619
(71) Applicant: Nissan Chemical Corporation, Tokyo 103-6119 (JP)
(72) Inventor: IZUMI, Akihito, Toyama-shi, Toyama 939-2792 (JP); ENDO, Masahisa, Toyama-shi, Toyama 939-2792 (JP)
(74) Representative: Hoffmann Eitle
(86) International application number: PCT/JP2024/012012
(87) International publication number: WO 2024/204232

(57) **Abstract**

[Problem] The purpose of the present invention is to provide: a resist underlayer film which is required to have resist underlayer film characteristics such as high density, high hardness and unbending properties after etching; a resist underlayer film forming composition which is capable of forming the resist underlayer film; a method for forming a resist pattern; and a method for manufacturing a semiconductor device.

[Solution] A resist underlayer film forming composition which contains a solvent and a polymer that is obtained by reacting a glycoluril compound with an aromatic compound having at least one phenolic hydroxyl group, wherein the nitrogen content ratio of the polymer is less than 10% by mass.

## Description

### TECHNICAL FIELD

The present invention relates to a resist underlayer film-forming composition suitable for lithography in semiconductor substrate processing, a resist underlayer film obtained from the resist underlayer film-forming composition, a method of forming a resist pattern using the resist underlayer film-forming composition, and a method of producing a semiconductor device using the composition.

### BACKGROUND ART

In recent years, semiconductor producing processes have rapidly advanced and in hybrid processes, a phenomenon in which materials bend after spin-on-carbon (SOC) etching has been observed. Therefore, there is a demand for materials that do not bend even after SOC etching. Accordingly, there is a strong demand for resist underlayer films with high hardness. The present invention has been made to develop film materials with high film hardness.

When the film density is improved, the film hardness is also improved accordingly. When the film density and the film hardness are higher, higher stress resistance during etching is obtained and film materials that are less prone to bending are obtained. The inventors found that, in order to increase the film density, when polymers are synthesized by polymerizing rigid and linear framework monomers in two dimensions (a planar structure), and additionally stacking them in three dimensions through π-π stacking and hydrogen bonding, and polymers containing hydroxyl groups with thermally crosslinkable sites are synthesized, high film density and high hardness can be achieved.

Specifically, they found that a polymer of a glycoluril compound having a substituent and a reactive comonomer having a phenolic hydroxyl group exhibited high film density and high hardness.

It has been reported that a glycoluril compound is contained in an anti-reflective coating-forming composition for use in a lithographic process for production of a semiconductor device, and an anti-reflective coating formed from the anti-reflective coating-forming composition effectively absorbs reflected light from a substrate when emission light with a wavelength of 248 nm, 193 nm, 157 nm or the like is used for microprocessing, does not allow intermixing with a photoresist layer, provides an excellent photoresist pattern, and has a higher dry etching rate than a photoresist (refer to Patent Document 1).

In addition, it has been reported that an anti-reflective coating formed from a coating composition containing a polymer, which can be obtained by reacting a glycoluril compound with at least one reactive compound containing at least one hydroxy group and/or at least one acid group, has properties of reducing reflection from a substrate even at short wavelength exposure and maintaining the lithographic performance of photoresists (refer to Patent Document 2).

However, although Patent Document 1 and Patent Document 2 mention the formation of a high-density and high-hardness film, no actual verification has been provided.

### Prior Art Documents

### Patent Documents

Patent Document 1: JP 2004-126161 A
Patent Document 2: JP No. 5613950 B2

### SUMMARY OF THE INVENTION

### Problem to be Solved by the Invention

With rapid advances in semiconductor producing processes, there is a strong demand for higher quality and improved properties of resist underlayer films. Resist underlayer films are required to have properties of high density, high hardness and resistance to bending after etching. The present invention provides a resist underlayer film-forming composition having these properties, a resist underlayer film obtained from the resist underlayer film-forming composition, a method of forming a resist pattern using the resist underlayer film-forming composition, and a method of producing a semiconductor device using the composition.

### Means for Solving the Problem

The present invention solves the above problems. Specifically, the present invention includes the following aspects.

A first aspect of the present invention relates to a resist underlayer film-forming composition comprising a polymer obtained by reacting a glycoluril compound with an aromatic compound having at least one phenolic hydroxyl group and a solvent, wherein a nitrogen content of the polymer is less than 10% by mass.

A second aspect of the present invention relates to the resist underlayer film-forming composition according to the first aspect, wherein a carbon content of the polymer is 80% or less.

A third aspect of the present invention relates to the resist underlayer film-forming composition according to the first aspect, wherein the glycoluril compound is a glycoluril compound substituted with at least one substituent, and the substituent is at least one substituent selected from the group consisting of a C₁₋₁₂ alkylol group, a C₂₋₁₂ alkoxyalkyl group, and a C₃₋₁₂ alkenyloxyalkyl group.

A fourth aspect of the present invention relates to the resist underlayer film-forming composition according to the first aspect, wherein the glycoluril compound is selected from the group consisting of tetramethylol glycoluril, tetrabutoxymethyl glycoluril, tetramethoxymethyl glycoluril, partially methylolated glycoluril, dimethoxymethyl glycoluril, monomethyl ether of dimethylol glycoluril or dimethyl ether of dimethylol glycoluril, trimethyl ether of tetramethylol glycoluril, tetramethyl ether of tetramethylol glycoluril, tetraethoxymethyl glycoluril, tetrapropoxymethyl glycoluril, tetraamyloxymethyl glycoluril, tetrahexoxymethyl glycoluril, and mixtures thereof.

A fifth aspect of the present invention relates to the resist underlayer film-forming composition according to the first aspect, wherein the glycoluril compound is a glycoluril compound substituted with at least a methoxymethyl group.

A sixth aspect of the present invention relates to the resist underlayer film-forming composition according to the first aspect, wherein the aromatic compound having a phenolic hydroxyl group is selected from among the following compounds:

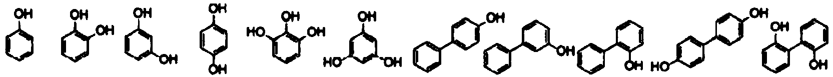

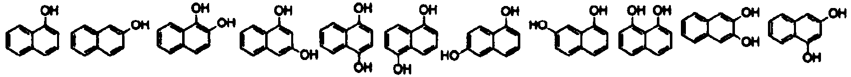

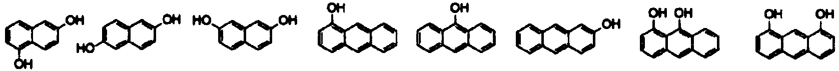

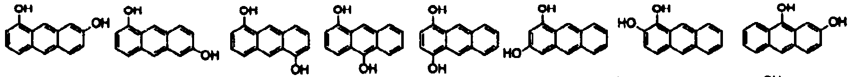

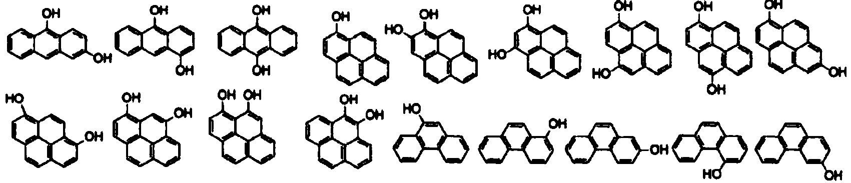

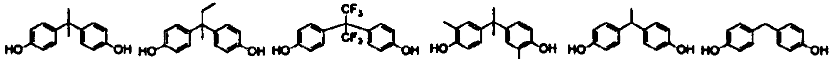

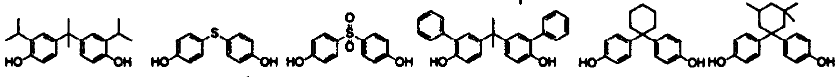

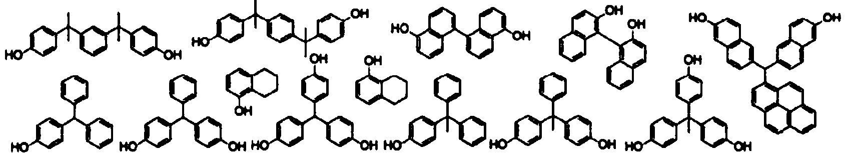

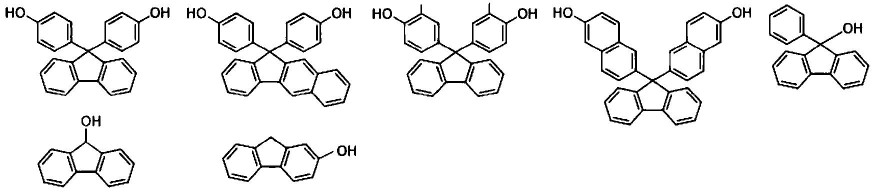

A seventh aspect of the present invention relates to the resist underlayer film-forming composition according to the first aspect, wherein the solvent is a solvent having a boiling point of 160°C or higher.

An eighth aspect of the present invention relates to the resist underlayer film-forming composition according to the first aspect, further comprising a crosslinking agent.

A ninth aspect of the present invention relates to the resist underlayer film-forming composition according to the eighth aspect, wherein the crosslinking agent is an aminoplast crosslinking agent, or an aminoplast crosslinking agent and a phenoplast crosslinking agent.

A tenth aspect of the present invention relates to the resist underlayer film-forming composition according to the first aspect, further comprising a surfactant.

An eleventh aspect of the present invention relates to the resist underlayer film-forming composition according to the first aspect, further comprising an acid and/or salts of the acid and/or an acid generating agent.

A twelfth aspect of the present invention relates to a resist underlayer film which is a baked product of a coating film formed of the composition according to any one of the first aspect to the eleventh aspect.

A thirteenth aspect of the present invention relates to a method of forming a resist pattern used in production of semiconductors, comprising: a step of applying the resist underlayer film-forming composition according to any one of the first aspect to the eleventh aspect onto a semiconductor substrate and baking to form a resist underlayer film; a step of forming a resist film on the resist underlayer film; and a step of forming a resist pattern on the resist film by emitting light or an electron beam and developing.

A fourteenth aspect of the present invention relates to a method of producing a semiconductor device, comprising: a step of applying the resist underlayer film-forming composition according to any one of the first aspect to the eleventh aspect onto a semiconductor substrate and baking to form a resist underlayer film; a step of forming a resist film on the resist underlayer film; a step of forming a resist pattern on the resist film; a step of etching the resist underlayer film using the resist pattern; and a step of processing the semiconductor substrate using the patterned resist underlayer film.

A fifteenth aspect of the present invention relates to the method of producing a semiconductor device according to the fourteenth aspect, wherein the resist pattern is formed on the resist film by emitting light or an electron beam and developing.

A sixteenth aspect of the present invention relates to the method of producing a semiconductor device according to the fourteenth aspect, wherein the resist pattern is formed on the resist film by a nanoimprinting method or a self-assembled film.

A seventeenth aspect of the present invention relates to a method of producing a semiconductor device, comprising: a step of applying the resist underlayer film-forming composition according to any one of the first aspect to the eleventh aspect onto a semiconductor substrate and baking to form a resist underlayer film; a step of forming a hard mask on the resist underlayer film; a step of additionally forming a resist film on the hard mask; a step of forming a resist pattern on the resist film; a step of etching the hard mask using the resist pattern; a step of etching the resist underlayer film using the patterned hard mask; and a step of processing the semiconductor substrate using the patterned resist underlayer film.

An eighteenth aspect of the present invention relates to the method of producing a semiconductor device according to the seventeenth aspect, wherein the hard mask is formed by applying a composition containing an inorganic substance or depositing a composition containing an inorganic substance.

A nineteenth aspect of the present invention relates to the method of producing a semiconductor device according to the seventeenth aspect, wherein the resist pattern is formed on the resist film by emitting light or an electron beam and developing.

A twentieth aspect of the present invention relates to the method of producing a semiconductor device according to the seventeenth aspect, wherein the resist pattern is formed on the resist film by a nanoimprinting method or a self-assembled film.

A twenty-first aspect of the present invention relates to a method of producing a semiconductor device, comprising: a step of applying the resist underlayer film-forming composition according to any one of the first aspect to the eleventh aspect onto a semiconductor substrate and baking to form a resist underlayer film; a step of forming a hard mask on the resist underlayer film; a step of additionally forming a resist film on the hard mask; a step of forming a resist pattern on the resist film; a step of etching the hard mask using the resist pattern; a step of etching the resist underlayer film using the patterned hard mask; a step of removing the hard mask; and a step of processing the semiconductor substrate using the patterned resist underlayer film.

A twenty-second aspect of the present invention relates to the method of producing a semiconductor device according to the twenty-first aspect, wherein the hard mask is formed by applying a composition containing an inorganic substance or depositing a composition containing an inorganic substance.

A twenty-third aspect of the present invention relates to the method of producing a semiconductor device according to the twenty-first aspect, wherein the resist pattern is formed on the resist film by emitting light or an electron beam and developing.

A twenty-fourth aspect of the present invention relates to the method of producing a semiconductor device according to the twenty-first aspect, wherein the resist pattern is formed on the resist film by a nanoimprinting method or a self-assembled film.

A twenty-fifth aspect of the present invention relates to the method of producing a semiconductor device according to the twenty-first aspect, wherein the hard mask is removed by etching or using an alkaline chemical solution.

A twenty-sixth aspect of the present invention relates to a method of producing a semiconductor device, comprising: a step of applying the resist underlayer film-forming composition according to any one of the first aspect to the eleventh aspect onto a semiconductor substrate and baking to form a resist underlayer film; a step of forming a hard mask on the resist underlayer film; a step of additionally forming a resist film on the hard mask; a step of forming a resist pattern on the resist film; a step of etching the hard mask using the resist pattern; a step of etching the resist underlayer film using the patterned hard mask; a step of removing the hard mask; a step of forming a vapor-deposited film (spacer) on the resist underlayer film after the hard mask is removed; a step of processing the vapor-deposited film (spacer) by etching; a step of removing the patterned resist underlayer film such that the patterned vapor-deposited film (spacer) remains; and a step of processing the semiconductor substrate using the patterned vapor-deposited film (spacer).

A twenty-seventh aspect of the present invention relates to the method of producing a semiconductor device according to the twenty-sixth aspect, wherein the hard mask is formed by applying a composition containing an inorganic substance or depositing a composition containing an inorganic substance.

A twenty-eighth aspect of the present invention relates to the method of producing a semiconductor device according to the twenty-sixth aspect, wherein the resist pattern is formed on the resist film by emitting light or an electron beam and developing.

A twenty-ninth aspect of the present invention relates to the method of producing a semiconductor device according to the twenty-sixth aspect, wherein the resist pattern is formed on the resist film by a nanoimprinting method or a self-assembled film.

A thirtieth aspect of the present invention relates to the method of producing a semiconductor device according to the twenty-sixth aspect, wherein the hard mask is removed by etching or using an alkaline chemical solution.

### Effects of the Invention

The resist underlayer film-forming composition of the present invention can form a high-film-density resist underlayer film by synthesizing polymers having a coplanar structure with a small free volume in two dimensions and additionally stacking them in three dimensions through hydrogen bonding. In addition, when polymers containing hydroxyl groups with thermally crosslinkable sites are synthesized, a resist underlayer film with higher hardness can be achieved. Such a high-film-density and high-hardness resist underlayer film can be widely applied to diversifying semiconductor producing processes.

### MODES FOR CARRYING OUT THE INVENTION

The resist underlayer film-forming composition of the present invention is a resist underlayer film-forming composition containing a polymer obtained by reacting a glycoluril compound with an aromatic compound having at least one phenolic hydroxyl group and a solvent. In addition, the composition may optionally contain a crosslinking agent, an acid generating agent or a surfactant.

Hereinafter, the components will be described in detail.

### <Glycoluril compound>

The glycoluril compound of the present invention is preferably a glycoluril compound substituted with at least one substituent. In addition, the glycoluril compound of the present invention may be of one type of glycoluril compound or may be used as a mixture.

Examples of substituents include a C₁₋₁₂ alkylol group, C₂₋₁₂ alkoxyalkyl group, and C₃₋₁₂ alkenyloxyalkyl group.

Preferable examples of C₁₋₁₂ alkylol groups include a methylol group, butylol group and ethylol group.

Preferable examples of C₂₋₁₂ alkoxyalkyl groups include a methoxymethyl group, ethoxymethyl group, propoxymethyl group, butoxymethyl group, pentyloxymethyl group, hexoxymethyl group, methoxyethyl group, ethoxyethyl group, propoxyethyl group, butoxyethyl group, methoxypropyl group, ethoxypropyl group, propoxypropyl group, butoxypropyl group, methoxybutyl group, ethoxybutyl group, propoxybutyl group, and butoxybutyl group.

Preferable examples of C₃₋₁₂ alkenyloxyalkyl groups include a vinyloxymethyl group, vinyloxyethyl group, vinyloxypropyl group, allyloxymethyl group, allyloxyethyl group, and allyloxypropyl group.

The glycoluril compound substituted with such a substituent is preferable, and is selected from the group consisting of tetramethylol glycoluril, tetrabutoxymethyl glycoluril, tetramethoxymethyl glycoluril, partially methylolated glycoluril, dimethoxymethyl glycoluril, monomethyl ether of dimethylol glycoluril, dimethyl ether of dimethylol glycoluril, trimethyl ether of tetramethylol glycoluril, tetramethyl ether of tetramethylol glycoluril, tetraethoxymethyl glycoluril, tetrapropoxymethyl glycoluril, tetraamyloxymethyl glycoluril, tetrahexoxymethyl glycoluril, and mixtures thereof.

### <Aromatic compound having phenolic hydroxyl group>

The aromatic compound having a phenolic hydroxyl group is selected from among the following compounds.

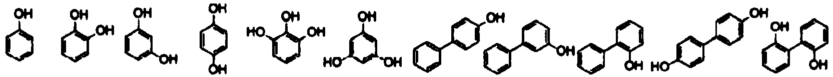

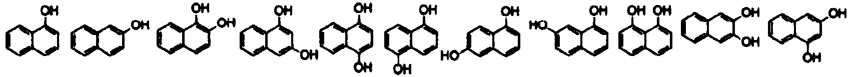

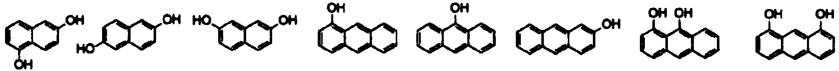

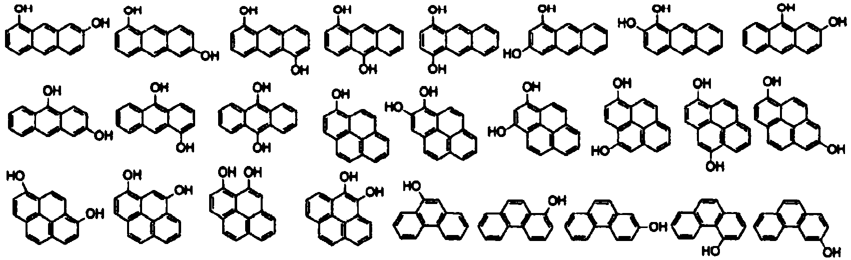

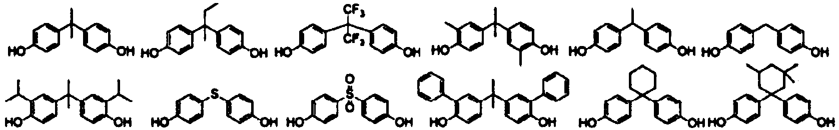

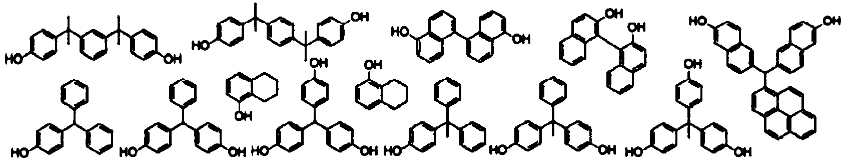

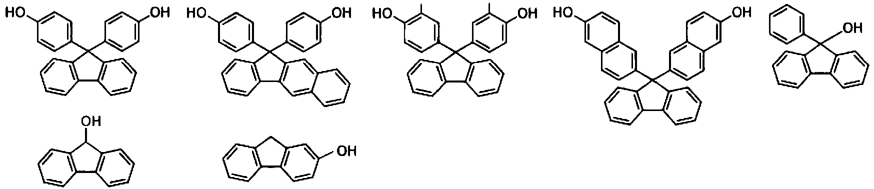

Preferably, the following aromatic compound having a phenolic hydroxyl group is selected from among the following compositions.

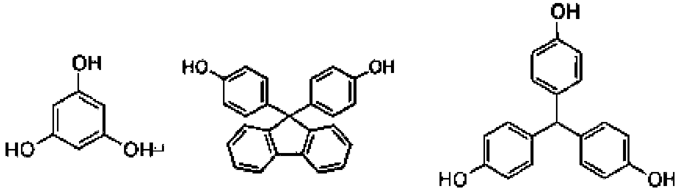

### <Production of polymer>

A polymer obtained by reacting a glycoluril compound with an aromatic compound having a phenolic hydroxyl group can be prepared by a known method. For example, a polymer can be prepared by condensing a glycoluril compound and an aromatic compound having a phenolic hydroxyl group.

The glycoluril compounds and the aromatic compounds having a phenolic hydroxyl group each may be used alone or two or more thereof may be used in combination. In this condensation reaction, per 1 mol of the glycoluril compound, the aromatic compound having a phenolic hydroxyl group can be used in a proportion of 0.1 to 10 mol, and preferably 0.1 to 2 mol.

Preferably, the nitrogen content of the polymer is less than 10% by mass. More preferably, the carbon content of the polymer is 80% or less.

The condensation reaction can be performed without a solvent, but are generally performed using a solvent. The solvent is not particularly limited as long as it can dissolve the reactant and does not inhibit the reaction. Examples thereof include ethers such as 1,2-dimethoxyethane, diethylene glycol dimethyl ether, propylene glycol monomethyl ether, propylene glycol monomethyl ether acetate, tetrahydrofuran, and dioxane. In addition, for example, if the catalyst used is a liquid such as formic acid, it can also serve as a solvent.

The condensation reaction temperature is generally 40°C to 200°C, and preferably 80°C to 180°C. The reaction time varies depending on the reaction temperature, but is generally 5 minutes to 50 hours, and preferably 5 minutes to 24 hours.

The weight average molecular weight of the polymer according to one aspect of the present invention is generally 500 to 100,000 and preferably 600 to 50,000, 700 to 10,000, or 800 to 8,000.

### <Solvent>

The resist underlayer film-forming composition according to one aspect of the present invention contains a solvent.

The solvent is not particularly limited as long as it can dissolve the polymer obtained by reacting a glycoluril compound with an aromatic compound having a phenolic hydroxyl group, and other optional components added as necessary.

Examples of solvents include methyl cellosolve acetate, ethyl cellosolve acetate, propylene glycol, propylene glycol monomethyl ether, propylene glycol monoethyl ether, propylene glycol monopropyl ether, methyl isobutyl carbinol, propylene glycol monobutyl ether, propylene glycol monomethyl ether acetate, propylene glycol monoethyl ether acetate, propylene glycol monopropyl ether acetate, propylene glycol monobutyl ether acetate, toluene, xylene, methyl ethyl ketone, cyclopentanone, cyclohexanone, ethyl 2-hydroxypropionate, ethyl 2-hydroxy-2-methylpropionate, ethyl ethoxyacetate, hydroxyethyl acetate, methyl 2-hydroxy-3-methyl butanoate, methyl 3-methoxypropionate, ethyl 3-methoxypropionate, ethyl 3-ethoxypropionate, methyl 3-ethoxypropionate, methyl pyruvate, ethyl pyruvate, ethylene glycol monomethyl ether, ethylene glycol monoethyl ether, ethylene glycol monopropyl ether, ethylene glycol monobutyl ether, ethylene glycol monomethyl ether acetate, ethylene glycol monoethyl ether acetate, ethylene glycol monopropyl ether acetate, ethylene glycol monobutyl ether acetate, diethylene glycol monomethyl ether, diethylene glycol monoethyl ether, diethylene glycol dimethyl ether, diethylene glycol diethyl ether, diethylene glycol dipropyl ether, diethylene glycol dibutyl ether, propylene glycol monomethyl ether, propylene glycol dimethyl ether, propylene glycol diethyl ether, propylene glycol dipropyl ether, propylene glycol dibutyl ether, ethyl lactate, propyl lactate, isopropyl lactate, butyl lactate, isobutyl lactate, methyl formate, ethyl formate, propyl formate, isopropyl formate, butyl formate, isobutyl formate, amyl formate, isoamyl formate, methyl acetate, ethyl acetate, amyl acetate, isoamyl acetate, hexyl acetate, methyl propionate, ethyl propionate, propyl propionate, isopropyl propionate, butyl propionate, isobutyl propionate, methyl butyrate, ethyl butyrate, propyl butyrate, isopropyl butyrate, butyl butyrate, isobutyl butyrate, hydroxyethyl acetate, methyl 2-hydroxy-2-methylpropionate, ethyl 2-hydroxy-2-methylpropionate, methyl 3-methoxy-2-methylpropionate, methyl 2-hydroxy-3-methylbutyrate, ethyl methoxyacetate, ethyl ethoxyacetate, methyl 3-methoxypropionate, ethyl 3-ethoxypropionate, ethyl 3-methoxypropionate, 3-methoxybutyl acetate, 3-methoxypropyl acetate, 3-methyl-3-methoxybutyl acetate, 3-methyl-3-methoxybutyl propionate, 3-methyl-3-methoxybutyl butyrate, methyl acetoacetate, toluene, xylene, methyl ethyl ketone, methyl propyl ketone, methyl butyl ketone, 2-heptanone, 3-heptanone, 4-heptanone, N,N-dimethylformamide, N-methylacetamide, N,N-dimethylacetamide, N-methylpyrrolidone, 4-methyl-2-pentanol, and γ-butyrolactone. These solvents can be used alone or two or more thereof can be used in combination.

In addition, a combination of a solvent with a boiling point of 160°C or higher and a solvent with a boiling point of lower than 160°C may be contained.

As such a high boiling point solvent, for example, the following compounds described in WO 2018/131562 A1 can be preferably used. 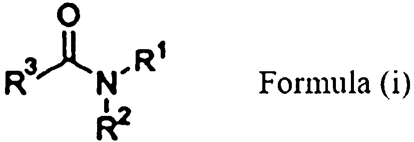 [in Formula (i), R¹, R² and R³ are each a hydrogen atom, an oxygen atom, a sulfur atom or a C₁₋₂₀ alkyl group which may have an intervening amide bond, and may be the same as or different from each other, and may be bonded to each other to form a ring structure].

Alternatively, 1,6-diacetoxyhexane (with a boiling point of 260°C) and tripropylene glycol monomethyl ether (with a boiling point of 242°C) described in JP 2021-84974 A, as well as various high boiling point solvents described in paragraph 0082 of the publication can be preferably used.

Alternatively, dipropylene glycol monomethyl ether acetate (with a boiling point of 213°C), diethylene glycol monoethyl ether acetate (with a boiling point of 217°C), diethylene glycol monobutyl ether acetate (with a boiling point of 247°C), dipropylene glycol dimethyl ether (with a boiling point of 171°C), dipropylene glycol monomethyl ether (with a boiling point of 187°C), dipropylene glycol monobutyl ether (with a boiling point of 231 °C), tripropylene glycol monomethyl ether (with a boiling point of 242°C), γ-butyrolactone (with a boiling point of 204°C), benzyl alcohol (with a boiling point of 205°C), propylene carbonate (with a boiling point of 242°C), tetraethylene glycol dimethyl ether (with a boiling point of 275°C), 1,6-diacetoxyhexane (with a boiling point of 260°C), dipropylene glycol (with a boiling point of 230°C), and 1,3-butylene glycol diacetate (with a boiling point of 232°C) described in JP 2019-20701 A, as well as various high boiling point solvents described in paragraphs 0023 to 0031 of the publication can be preferably used.

### <Acid and/or salts of the acid and/or acid generating agent>

The resist underlayer film-forming composition according to one aspect of the present invention can contain an acid and/or salts of the acid and/or an acid generating agent.

Examples of acids include p-toluenesulfonic acid, trifluoromethanesulfonic acid, salicylic acid, 5-sulfosalicylic acid, 4-phenolsulfonic acid, camphorsulfonic acid, 4-chlorobenzenesulfonic acid, benzenedisulfonic acid, 1-naphthalenesulfonic acid, citric acid, benzoic acid, hydroxybenzoic acid, and naphthalenecarboxylic acid.

As the salt, salts of the above acids can be used. Although the salt is not limited, ammonia derivative salts such as trimethylamine salts and triethylamine salts, pyridine derivative salts, morpholine derivative salts and the like can be suitably used.

Acids and/or salts of the acids can be used alone or two or more thereof can be used in combination. The amount added with respect to a total solid content is generally 0.0001 to 20% by mass, preferably 0.0005 to 10% by mass, and more preferably 0.01 to 5% by mass.

Examples of acid generating agents include thermal acid generating agents and photoacid generating agents.

Examples of thermal acid generating agents include 2,4,4,6-tetrabromocyclohexadienone, benzoin tosylate, 2-nitrobenzyl tosylate, K-PURE [registered trademark] CXC-1612, CXC-1614, TAG-2172, TAG-2179, TAG-2678, TAG2689, and TAG2700 (commercially available from King Industries), SI-45, SI-60, SI-80, SI-100, SI-110, and SI-150 (commercially available from Sanshin Chemical Industry Co., Ltd.), and other organic sulfonic acid alkyl esters.

The photoacid generating agent generates an acid when the resist is exposed. Therefore, the acidity of the underlayer film can be adjusted. This is a method of adjusting the acidity of the underlayer film to the acidity of the upper layer resist. In addition, when the acidity of the underlayer film is adjusted, it is possible to adjust the pattern shape of the resist formed on the upper layer.

Examples of photoacid generating agents contained in the resist underlayer film-forming composition of the present invention include onium salt compounds, sulfonimide compounds, and disulfonyldiazomethane compounds.

Examples of onium salt compounds include iodonium salt compounds such as diphenyliodonium hexafluorophosphate, diphenyliodonium trifluoromethanesulfonate, diphenyliodonium nonafluoro-n-butanesulfonate, diphenyliodonium perfluoro-n-octanesulfonate, diphenyliodonium camphorsulfonate, bis(4-tert-butylphenyl)iodonium camphorsulfonate and bis(4-tert-butylphenyl)iodonium trifluoromethanesulfonate, as well as sulfonium salt compounds such as triphenylsulfonium hexafluoroantimonate, triphenylsulfonium nonafluoro-n-butanesulfonate, triphenylsulfonium camphorsulfonate and triphenylsulfonium trifluoromethanesulfonate.

Examples of sulfonimide compounds include N-(trifluoromethanesulfonyloxy)succinimide, N-(nonafluoro-n-butanesulfonyloxy)succinimide, N-(camphorsulfonyloxy)succinimide and N-(trifluoromethanesulfonyloxy)naphthalimide.

Examples of disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyldiazomethane.

The acid generating agents can be used alone or two or more thereof can be used in combination.

When an acid generating agent is used, the proportion thereof with respect to a solid content of 100 parts by mass of the resist underlayer film-forming composition is 0.01 to 10 parts by mass, 0.1 to 8 parts by mass, or 0.5 to 5 parts by mass.

### <Other optional components>

The resist underlayer film-forming composition according to one aspect of the present invention can contain, as necessary, a crosslinking agent, a surfactant, a light absorbing agent, a rheology adjusting agent, an adhesive auxiliary agent, a curing catalyst and the like in addition to the above components.

### <Crosslinking agent>

Examples of representative crosslinking agents include aminoplast crosslinking agents and phenoplast crosslinking agents.

As the crosslinking agent, a crosslinking agent having high heat resistance can be used. As the crosslinking agent having high heat resistance, a compound containing a crosslink-forming substituent having an aromatic ring (for example, a benzene ring or a naphthalene ring) in the molecule can be preferably used.

Examples of aminoplast crosslinking agents include highly alkylated, alkoxylated, or alkoxyalkylated melamines, benzoguanamines, glycolurils, ureas, and polymers thereof. A crosslinking agent having at least two crosslink-forming substituents is preferable, and is a compound such as methoxymethylated glycoluril, butoxymethylated glycoluril, methoxymethylated melamine, butoxymethylated melamine, methoxymethylated benzoguanamine, butoxymethylated benzoguanamine, methoxymethylated urea, butoxymethylated urea, methoxymethylated thiourea, or methoxymethylated thiourea. In addition, a condensation product of these compounds can also be used.

At least one selected from the group consisting of tetramethoxymethyl glycoluril and hexamethoxymethylmelamine is preferable.

Some specific examples are as follows.

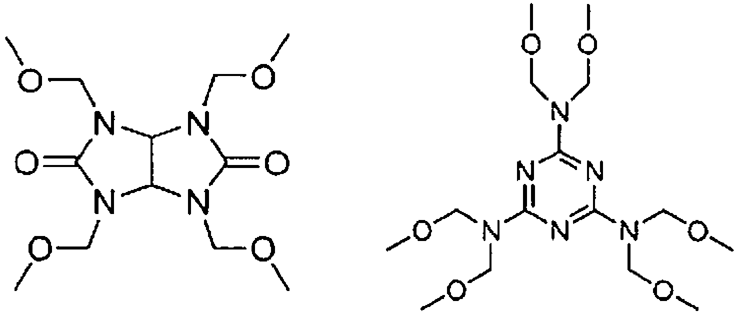

Examples of phenoplast crosslinking agents include highly alkylated, alkoxylated, or alkoxyalkylated aromatics, and polymers thereof. A crosslinking agent having at least two crosslink-forming substituents in one molecule is preferable, and is a compound such as 2,6-dihydroxymethyl-4-methylphenol, 2,4-dihydroxymethyl-6-methylphenol, bis(2-hydroxy-3-hydroxymethyl-5-methylphenyl)methane, bis(4-hydroxy-3-hydroxymethyl-5-methylphenyl)methane, 2,2-bis(4-hydroxy-3,5-dihydroxymethylphenyl)propane, bis(3-formyl-4-hydroxyphenyl)methane, bis(4-hydroxy-2,5-dimethylphenyl)formylmethane, or α,α-bis(4-hydroxy-2,5-dimethylphenyl)-4-formyltoluene. In addition, a condensation product of these compounds can also be used.

In addition to the above examples, examples of such compounds include compounds having a partial structure of the following Formula (4) and polymers or oligomers having a repeating unit of the following Formula (5).

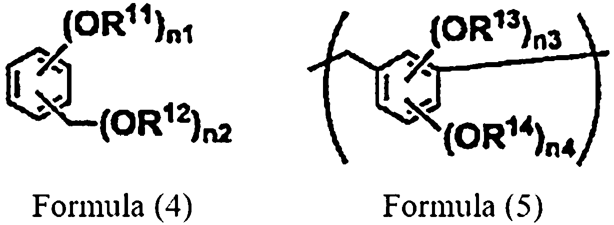

R¹¹, R¹², R¹³, and R¹⁴ are a hydrogen atom or a C₁₋₁₀ alkyl group, and the above examples can be used as these alkyl groups. n1 is an integer of 1 to 4, n2 is an integer of 1 to (5 - n1), and (n1 + n2) is an integer of 2 to 5. n3 is an integer of 1 to 4, n4 is 0 to (4 - n3), and (n3 + n4) is an integer of 1 to 4. Oligomers and polymers having a number of repeating unit structures in a range of 2 to 100 or 2 to 50 can be used.

Some specific examples are as follows.

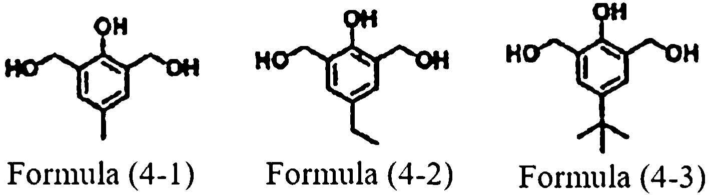

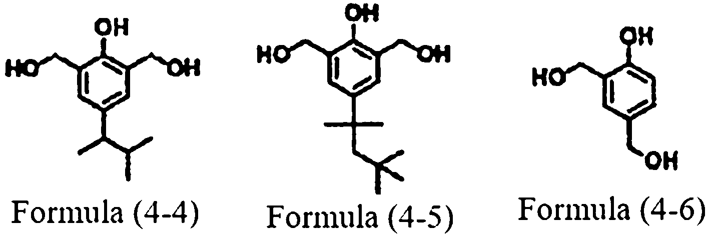

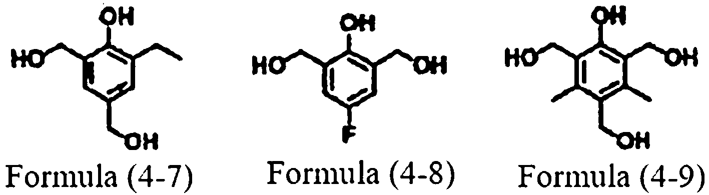

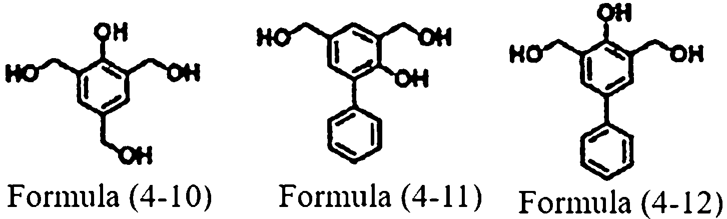

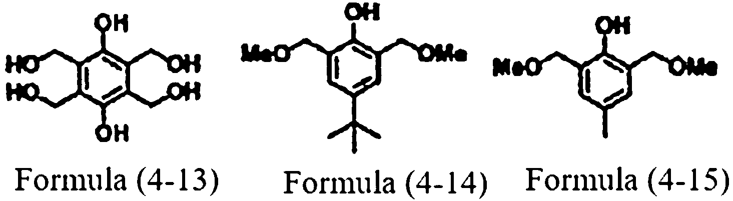

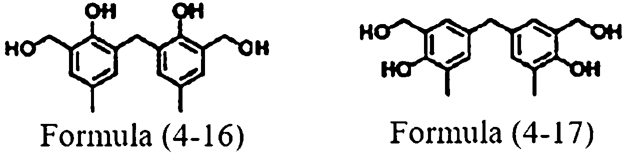

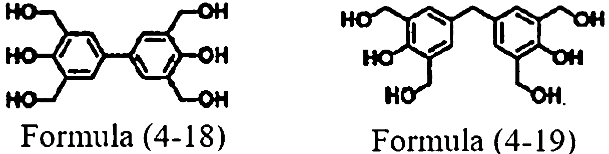

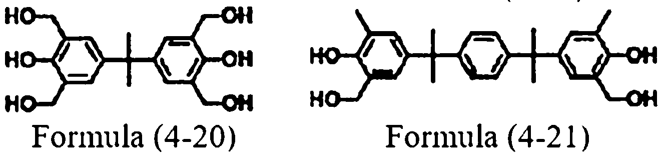

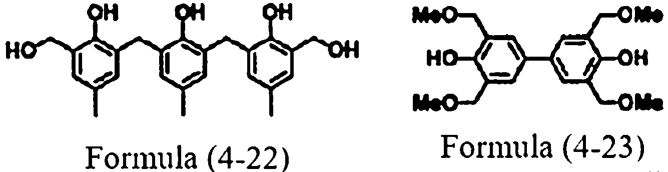

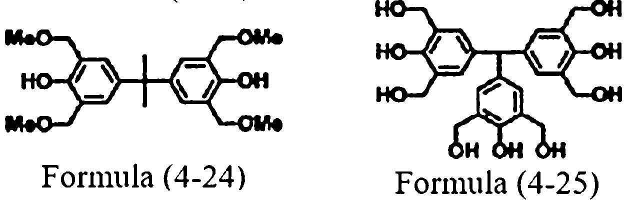

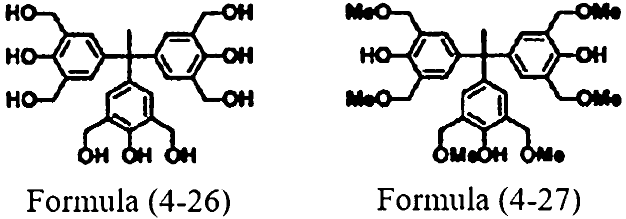

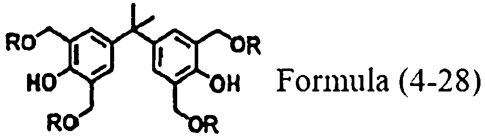

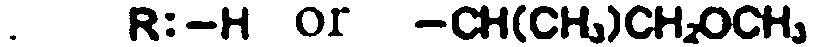

The crosslinking agents such as aminoplast crosslinking agents and phenoplast crosslinking agents may be used alone or two or more thereof may be used in combination. For example, only the aminoplast crosslinking agent may be used, or both the aminoplast crosslinking agent and the phenoplast crosslinking agent may be used. The aminoplast crosslinking agent can be produced by a method known per se or a method similar thereto, or commercially available products may be used.

In addition, the used amount of the crosslinking agent such as an aminoplast crosslinking agent or a phenoplast crosslinking agent varies depending on a coating solvent used, a base substrate used, a required solution viscosity, a required film shape and the like, but is 0.001% by mass or more, 0.01% by mass or more, 0.05% by mass or more, 0.5% by mass or more, or 1.0% by mass or more, and 80% by mass or less, 50% by mass or less, 40% by mass or less, 20% by mass or less, or 10% by mass or less with respect to a total solid content of the resist underlayer film-forming composition according to the present invention.

### <Surfactant>

In the resist underlayer film-forming composition according to the present invention, in order to prevent pinholes, striations or the like from being generated and further improve coverage against surface unevenness, a surfactant can be added.

Examples of surfactants include nonionic surfactants, for example, polyoxyethylene alkyl ethers such as polyoxyethylene lauryl ether, polyoxyethylene stearyl ether, polyoxyethylene cetyl ether, and polyoxyethylene oleyl ether; polyoxyethylene alkylaryl ethers such as polyoxyethylene octylphenol ether and polyoxyethylene nonylphenol ether; polyoxyethylene-polyoxypropylene block copolymers; sorbitan fatty acid esters such as sorbitan monolaurate, sorbitan monopalmitate, sorbitan monostearate, sorbitan monooleate, sorbitan trioleate, and sorbitan tristearate; and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants such as EFTOP EF301, EF303, and EF352 (product name, commercially available from Tochem Products Co., Ltd.), Megaface F171, F173, R-30, and R-40 (product name, commercially available from Dainippon Ink and Chemicals), Fluorad FC430, and FC431 (product name, commercially available from Sumitomo 3M Ltd.), AsahiGuard AG710, Surflon S-382, SC101, SC102, SC103, SC104, SC105, and SC106 (product name, commercially available from Asahi Glass Co., Ltd.), and organosiloxane polymer KP341 (commercially available from Shin-Etsu Chemical Co., Ltd.).

The amount of these surfactants added is generally 2.0% by mass or less and preferably 1.0% by mass or less with respect to a total solid content of the resist underlayer film-forming composition according to the present invention. These surfactants may be added alone or two or more thereof may be added in combination.

### <Other additives>

As the light absorbing agent, for example, commercially available light absorbing agents described in "A Technology and Market of Industrial Dyes" (CMC publishing) and "A Handbook of Dyes" (edited by The Society of Synthetic Organic Chemistry), for example, C. I. Disperse Yellow 1, 3, 4, 5, 7, 8, 13, 23, 31, 49, 50, 51, 54, 60, 64, 66, 68, 79, 82, 88, 90, 93, 102, 114 and 124; C. I. Disperse Orange 1, 5, 13, 25, 29, 30, 31, 44, 57, 72 and 73; C. I. Disperse Red 1, 5, 7, 13, 17, 19, 43, 50, 54, 58, 65, 72, 73, 88, 117, 137, 143, 199 and 210; C. I. Disperse Violet 43; C. I. Disperse Blue 96; C. I. Fluorescent Brightening Agent 112, 135 and 163; C. I. Solvent Orange 2 and 45; C. I. Solvent Red 1, 3, 8, 23, 24, 25, 27 and 49; C. I. Pigment Green 10; C. I. Pigment Brown 2 and the like can be suitably used. The light absorbing agent is added in a proportion of generally 10% by mass or less and preferably 5% by mass or less with respect to a total solid content of the resist underlayer film-forming composition according to the present invention.

The rheology adjusting agent is mainly added in order to improve the fluidity of the resist underlayer film-forming composition, improve the uniformity of the film thickness of the resist underlayer film particularly in a baking step, and improve the ability of the resist underlayer film-forming composition to fill the hole. Specific examples thereof include phthalic acid derivatives such as dimethyl phthalate, diethyl phthalate, diisobutyl phthalate, dihexyl phthalate, and butyl isodecyl phthalate, adipic acid derivatives such as di-n-butyl adipate, diisobutyl adipate, diisooctyl adipate, and octyldecyl adipate, maleic acid derivatives such as di-n-butyl maleate, diethyl malate, and dinonyl maleate, oleic acid derivatives such as methyl oleate, butyl oleate, and tetrahydrofurfuryl oleate, and stearic acid derivatives such as n-butyl stearate and glyceryl stearate. These rheology adjusting agents are added in a proportion of generally less than 30% by mass with respect to a total solid content of the resist underlayer film-forming composition according to the present invention.

The adhesive auxiliary agent is mainly added in order to improve the adhesion between the substrate or the resist and the resist underlayer film-forming composition, and prevent the resist from peeling off particularly during development. Specific examples thereof include chlorosilanes such as trimethylchlorosilane, dimethylvinylchlorosilane, methyldiphenylchlorosilane, and chloromethyldimethylchlorosilane; alkoxysilanes such as trimethylmethoxysilane, dimethyldiethoxysilane, methyldimethoxysilane, dimethylvinylethoxysilane, diphenyldimethoxysilane, and phenyltriethoxysilane; silazanes such as hexamethyldisilazane, N,N'-bis(trimethylsilyl)urea, dimethyltrimethylsilylamine, and trimethylsilylimidazole; silanes such as vinyltrichlorosilane, γ-chloropropyltrimethoxysilane, γ-aminopropyltriethoxysilane, and γ-glycidoxypropyltrimethoxysilane; heterocyclic compounds such as benzotriazole, benzimidazole, indazole, imidazole, 2-mercaptobenzimidazole, 2-mercaptobenzothiazole, 2-mercaptobenzoxazole, urazole, thiouracil, mercaptoimidazole, and mercaptopyrimidine; ureas such as 1,1-dimethylurea and 1,3-dimethylurea; and thiourea compounds. These adhesive auxiliary agents are added in a proportion of generally less than 5% by mass, and preferably less than 2% by mass with respect to a total solid content of the resist underlayer film-forming composition according to the present invention.

The curing catalyst is effective for curing the film. Specific examples thereof include, but are not limited to, sulfonium salt compounds such as triphenylsulfonium nitrate, triphenylsulfonium maleate, triphenylsulfonium trifluoroacetate, triphenylsulfonium hydrochloride, and triphenylsulfonium acetate.

The solid content of the resist underlayer film-forming composition according to the present invention is 0.1 to 70% by mass, or 0.1 to 60% by mass. The solid content is content of all components excluding the solvent from the resist underlayer film-forming composition. The solid content may contain a crosslinkable resin in a proportion of 1 to 99.9% by mass, 50 to 99.9% by mass, 50 to 95% by mass, or 50 to 90% by mass.

### <Resist underlayer film>

For example, the resist underlayer film can be formed using the resist underlayer film-forming composition according to the present invention as follows.

A resist underlayer film is formed by applying the resist underlayer film-forming composition according to one aspect of the present invention onto a substrate (for example, a silicon wafer substrate, a silicon dioxide coated substrate (SiO₂ substrate), a silicon nitride substrate (SiN substrate), a silicon oxynitride substrate (SiON substrate), a titanium nitride substrate (TiN substrate), a tungsten substrate (W substrate), a glass substrate, an ITO substrate, a polyimide substrate, and a low-dielectric-constant material (low-k material)-coated substrate or the like) used in the production of a semiconductor device by an appropriate coating method such as using a spinner or a coater, and then baked using a heating unit such as a hot plate. Baking conditions are appropriately selected from among a baking temperature of 80°C to 800°C and a baking time of 0.3 to 60 minutes. Preferably, the baking temperature is 150°C to 400°C, and the baking time is 0.5 to 2 minutes. As the atmospheric gas during baking, air may be used, and an inert gas such as nitrogen or argon can also be used. In one aspect, the oxygen concentration is particularly preferably 1% or less. Here, the film thickness of the underlayer film formed is, for example, 10 to 1,000 nm, 20 to 500 nm, 30 to 400 nm, or 50 to 300 nm. In addition, if a quartz substrate is used as the substrate, a quartz imprint mold replica (mold replica) can be produced.

In addition, an adhesion layer and/or a silicon-containing layer which contains 99% by mass or less or 50% by mass or less of Si can be formed on the resist underlayer film according to one aspect of the present invention by application or vapor deposition. For example, in addition to a method of forming_an adhesion layer described in JP 2013-202982 A and JP No. 5827180 B2, or a silicon-containing resist underlayer film (inorganic resist underlayer film)-forming composition described in WO 2009/104552 A1 by spin coating, a Si-based inorganic material film can be formed by a CVD method or the like.

In addition, the resist underlayer film-forming composition according to one aspect of the present invention is applied onto a semiconductor substrate having a portion with a step and a portion without a step (a so-called step substrate) and baked, and thus the step between the portion with a step and the portion without a step can be reduced.

### <Method of forming resist pattern>

A method of forming a resist pattern used in the production of a semiconductor includes a step of applying the resist underlayer film-forming composition according to the present invention onto a substrate used in the production of the semiconductor device and baking to form a resist underlayer film, a step of forming a resist film on the resist underlayer film, and a step of forming a resist pattern on the resist film by emitting light or an electron beam and developing.

### <Method of producing semiconductor device>

(i) A method of producing a semiconductor device according to one aspect of the present invention includes
   a step of applying the resist underlayer film-forming composition according to one aspect of the present invention onto a semiconductor substrate and baking to form a resist underlayer film,
   a step of forming a resist film on the resist underlayer film,
   a step of forming a resist pattern on the resist film by emitting light or an electron beam and developing,
   a step of etching and patterning the resist underlayer film using the resist pattern,
      and
   a step of processing the semiconductor substrate using the patterned resist underlayer film.
(ii) In addition, a method of producing a semiconductor device according to one aspect of the present invention includes
   a step of applying the resist underlayer film-forming composition according to one aspect of the present invention onto a semiconductor substrate and baking to form a resist underlayer film,
   a step of forming a hard mask on the resist underlayer film,
   a step of additionally forming a resist film on the hard mask,
   a step of forming a resist pattern on the resist film by emitting light or an electron beam and developing,
   a step of etching and patterning the hard mask using the resist pattern,
   a step of etching and patterning the resist underlayer film using the patterned hard mask, and
   a step of processing the semiconductor substrate using the patterned resist underlayer film.
(iii) In addition, a method of producing a semiconductor device according to one aspect of the present invention includes
   a step of applying the resist underlayer film-forming composition according to one aspect of the present invention onto a semiconductor substrate and baking to form a resist underlayer film,
   a step of forming a hard mask on the resist underlayer film,
   a step of additionally forming a resist film on the hard mask,
   a step of forming a resist pattern on the resist film by emitting light or an electron beam and developing,
   a step of etching and patterning the hard mask using the resist pattern,
   a step of etching and patterning the resist underlayer film using the patterned hard mask,
   a step of removing the hard mask, and
   a step of processing the semiconductor substrate using the patterned resist underlayer film.
(iv) In addition, a method of producing a semiconductor device according to one aspect of the present invention includes
   a step of applying the resist underlayer film-forming composition according to one aspect of the present invention onto a semiconductor substrate and baking to form a resist underlayer film,
   a step of forming a hard mask on the resist underlayer film,
   a step of additionally forming a resist film on the hard mask,
   a step of forming a resist pattern on the resist film by emitting light or an electron beam and developing,
   a step of etching and patterning the hard mask using the resist pattern,
   a step of etching and patterning the resist underlayer film using the etched hard mask,
   a step of removing the hard mask,
   a step of forming a vapor-deposited film (spacer) on the resist underlayer film after the hard mask is removed,
   a step of processing the vapor-deposited film (spacer) by etching,
   a step of removing the patterned resist underlayer film such that the patterned vapor-deposited film (spacer) remains, and
   a step of processing the semiconductor substrate using the patterned vapor-deposited film (spacer).

A semiconductor substrate can be processed using the above production methods (i) to (iv).

The step of forming a resist underlayer film using the resist underlayer film-forming composition according to one aspect of the present invention is as described above in the <resist underlayer film> section.

A hard mask such as a silicon-containing film may be formed as a second resist underlayer film on the resist underlayer film formed by the step, and a resist pattern may be formed thereon [the above (ii) to (iv)].

The hard mask may be a coating film formed of a composition containing an inorganic substance or a vapor-deposited film formed of an inorganic substance formed by a vapor deposition method such as a CVD or PVD, and examples thereof include a SiON film, a SiN film and a SiO₂ film.

In addition, an anti-reflective coating (BARC) may be formed on the hard mask, or a resist shape correction film without anti-reflective properties may be formed.

In the step of forming the resist pattern, exposure is performed through a mask (reticle) for forming a predetermined pattern or direct writing. As an exposure source, for example, a g-line, an i-line, KrF excimer laser, ArF excimer laser, EUV, or an electron beam can be used. After exposure, as necessary, post-exposure bake is performed. Then, development is performed using a developing solution (for example, a 2.38% by mass tetramethylammonium hydroxide aqueous solution), and rinsing with a rinse solution or pure water is additionally performed to remove the used developing solution. Then, post-bake is performed to dry the resist pattern and to improve adhesion to the base.

The etching step performed after the resist pattern is formed is performed by dry etching.

The resist film may be patterned by a nanoimprinting method or a self-assembled film method.

In the nanoimprinting method, a resist composition is formed using a mold (form) that is transparent to emitted light and has a pattern formed thereon. In addition, in the self-assembled film method, a pattern is formed using a self-assembled film that naturally forms a regular structure on the nanometer order such as a diblock polymer (polystyrene-polymethyl methacrylate, etc.).

In the nanoimprinting method, before a curable composition that forms a resist film is applied, a silicon-containing layer (hard mask layer) may be optionally formed on the resist underlayer film by application or vapor deposition, an adhesion layer may be additionally formed on the resist underlayer film or on the silicon-containing layer (hard mask layer) by application or vapor deposition, and the curable composition that forms a resist film may be applied onto the adhesion layer.

Here, the following gases, that is, CF₄, CHF₃, CH₂F₂, CH₃F, C₄F₆, C₄F₈, O₂, N₂O, NO₂, He, and H₂, can be used to process the hard mask (silicon-containing layer), the resist underlayer film and the substrate. These gases may be used alone or a mixture of two or more gases may be used. In addition, these gases that are mixed with argon, nitrogen, carbon dioxide, carbonyl sulfide, sulfur dioxide, neon, or nitrogen trifluoride can be used.

Here, a wet etching treatment may be performed to simplify the process step and reduce damage to the processed substrate. This leads to minimizing fluctuations in processing dimensions and reducing the pattern roughness and makes it possible to process the substrate with a high yield. Therefore, in the above (iii) and (iv), the hard mask can be removed by etching or using an alkaline chemical solution. Particularly, when an alkaline chemical solution is used, there are no restrictions on components, but it is preferable that the alkaline component contain the following examples.

Examples of alkaline components include tetramethylammonium hydroxide, tetraethylammonium hydroxide, tetrapropylammonium hydroxide, tetrabutylammonium hydroxide, methyltripropylammonium hydroxide, methyltributylammonium hydroxide, ethyltrimethylammonium hydroxide, dimethyldiethylammonium hydroxide, benzyltrimethylammonium hydroxide, hexadecyltrimethylammonium hydroxide, (2-hydroxyethyl)trimethylammonium hydroxide, monoethanolamine, diethanolamine, triethanolamine, 2-(2-aminoethoxy)ethanol, N,N-dimethylethanolamine, N,N-diethylethanolamine, N,N-dibutylethanolamine, N-methylethanolamine, N-ethylethanolamine, N-butylethanolamine, N-methyldiethanolamine, monoisopropanolamine, diisopropanolamine, triisopropanolamine, tetrahydrofurfurylamine, N-(2-aminoethyl)piperazine, 1,8-diazabicyclo[5.4.0]undecene-7, 1,4-diazabicyclo[2.2.2]octane, hydroxyethyl piperazine, piperazine, 2-methylpiperazine, trans-2,5-dimethylpiperazine, cis-2,6-dimethylpiperazine, 2-piperidinemethanol, cyclohexylamine, and 1,5-diazabicyclo[4,3,0]nonene-5.

In addition, particularly, in consideration of handling, tetramethylammonium hydroxide and tetraethylammonium hydroxide are particularly preferable, and an inorganic base may be used in combination with quaternary ammonium hydroxide. As the inorganic base, alkali metal hydroxides such as potassium hydroxide, sodium hydroxide, and rubidium hydroxide are preferable, and potassium hydroxide is more preferable.

### [Examples]

Hereinafter, the present invention will be described in more detail with reference to synthesis examples, examples and comparative examples, but the present invention is not limited to the following examples.

### [Synthesis of polymer]

The weight average molecular weight shown in the following synthesis examples in this specification was the result measured through gel permeation chromatography (hereinafter abbreviated as GPC in this specification). For the measurement, a GPC device (HLC-8320GPC, commercially available from Tosoh Corporation) was used, and measurement conditions and the like are as follows.
GPC column: TSKgel SuperH-RC, TSKgel SuperMultipore HZ-N, TSKgel SuperMultipore HZ-N (commercially available from Tosoh Corporation)
Column temperature: 40°C
Solvent: tetrahydrofuran (for high-performance liquid chromatography, commercially available from Kanto Chemical Co., Inc.)
Standard sample: polystyrene (commercially available from Shodex)

### <Synthesis Example 1> Synthesis of polymer (1) (PL-LI/PGA = 100/100))

15.00 g (47.12 mmol) of tetramethoxymethyl glycoluril (POWDERLINK1174, commercially available from Mitsui Cytec Ltd.), 5.94 g (47.12 mmol) of phloroglucinol (commercially available from Tokyo Chemical Industry Co., Ltd.), 0.02 g (0.24 mmol) of methanesulfonic acid (commercially available from Tokyo Chemical Industry Co., Ltd.), and 83.75 g of propylene glycol monomethyl ether were put into a 200 mL three-neck flask including a stirring bar and a cooling pipe, the temperature was raised to 50°C, and the mixture was stirred at 50°C for 9 hours. After the reaction was stopped, the mixture was added dropwise to 732 g of water to precipitate the polymer. The obtained precipitate was filtered off, and the residue was washed three times with 183 mL of water and vacuum-dried to obtain a polymer. The molecular weight of this polymer was measured by GPC (standard polystyrene equivalent), the weight average molecular weight (Mw) was 1,413, and the yield was 58.4%. This polymer had a repeating unit structure of the following Formula (1). The obtained polymer was diluted with propylene glycol monomethyl ether to a solid content concentration of 30%, a cation exchange resin and an anion exchange resin in the same amounts as the solid content were added respectively, and the mixture was stirred for 4 hours. The ion exchange resin was filtered to obtain a polymer solution.

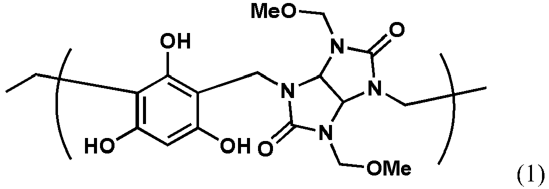

### <Synthesis Example 2> Synthesis of polymer (2) (PL-LI/THPE = 100/100))

5.00 g (15.71 mmol) of tetramethoxymethyl glycoluril (POWDERLINK1 174, commercially available from Mitsui Cytec Ltd.), 4.81 g (15.71 mmol) of 1,1,1-tris(4-hydroxyphenyl)ethane (commercially available from Tokyo Chemical Industry Co., Ltd.), 0.0075 g (0.08 mmol) of methanesulfonic acid (commercially available from Tokyo Chemical Industry Co., Ltd.), and 39.24 g of propylene glycol monomethyl ether were put into a 100 mL three-neck flask including a stirring bar and a cooling pipe, the temperature was raised to 50°C, and the mixture was stirred at 50°C for 6 hours. After the reaction was stopped, the mixture was added dropwise to a mixed solvent containing 392 g of methanol (Guaranteed Reagent, commercially available from Kanto Chemical Co., Inc.)/water (5/5) to precipitate the polymer. The obtained precipitate was filtered off, and the residue was washed three times with a mixed solvent containing 98 mL of methanol/water (5/5) and vacuum-dried to obtain a polymer. The molecular weight of this polymer was measured by GPC (standard polystyrene equivalent), the weight average molecular weight (Mw) was 850, and the yield was 50.9%. This polymer had a repeating unit structure of the following Formula (2). The obtained polymer was diluted with propylene glycol monomethyl ether to a solid content concentration of 30%, a cation exchange resin and an anion exchange resin in the same amounts as the solid content were added respectively, and the mixture was stirred for 4 hours. The ion exchange resin was filtered to obtain a polymer solution.

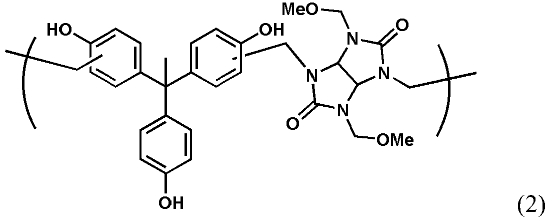

### <Synthesis Example 3> Synthesis of polymer (3) (PL-LI/BHPF = 100/100))

5.00 g (15.71 mmol) of tetramethoxymethyl glycoluril (POWDERLINK1174, commercially available from Mitsui Cytec Ltd.), 5.50 g (15.71 mmol) of 9,9-bis(4-hydroxyphenyl)fluorine (commercially available from Tokyo Chemical Industry Co., Ltd.), 0.0075 g (0.08 mmol) of methanesulfonic acid (commercially available from Tokyo Chemical Industry Co., Ltd.), and 42.01 g of propylene glycol monomethyl ether were put into a 100 mL three-neck flask including a stirring bar and a cooling pipe, the temperature was raised to 50°C, and the mixture was stirred at 50°C for 6 hours. After the reaction was stopped, the mixture was added dropwise to a mixed solvent containing 410 g of methanol (Guaranteed Reagent, commercially available from Kanto Chemical Co., Inc.)/water (5/5) to precipitate the polymer. The obtained precipitate was filtered off, the residue was washed three times with a mixed solvent containing 105 mL of methanol/water (5/5) and vacuum-dried to obtain a polymer. The molecular weight of this polymer was measured by GPC (standard polystyrene equivalent), the weight average molecular weight (Mw) was 2,125, and the yield was 64.4%. This polymer had a repeating unit structure of the following Formula (3). The obtained polymer was diluted with propylene glycol monomethyl ether to a solid content concentration of 30%, a cation exchange resin and an anion exchange resin in the same amounts as the solid content were added respectively, and the mixture was stirred for 4 hours. The ion exchange resin was filtered to obtain a polymer solution.

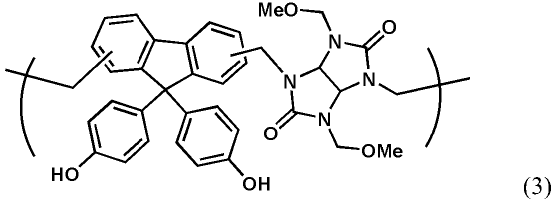

### <Comparative Synthesis Example 1>) Synthesis of polymer (S1) (PL-LI/styrene glycol = 100/100)

5.00 g (15.71 mmol) of tetramethoxymethyl glycoluril (POWDERLINK1 174, commercially available from Mitsui Cytec Ltd.), 2.17 g (15.71 mmol) of styrene glycol (commercially available from Tokyo Chemical Industry Co., Ltd.), 0.0299 g (0.16 mmol) of para-toluenesulfonic acid monohydrate (commercially available from Tokyo Chemical Industry Co., Ltd.), and 28.65 g of propylene glycol monomethyl ether acetate were put into a 100 mL three-neck flask including a stirring bar and a cooling pipe, the temperature was raised to 85°C, and the mixture was stirred at 85°C for 4 hours. After the reaction was stopped, a cation exchange resin and an anion exchange resin in same amounts as the solid content were added respectively to the obtained reaction solution, and the mixture was stirred for 4 hours. The ion exchange resin was filtered to obtain a polymer solution. The weight average molecular weight (Mw) measured by GPC (standard polystyrene equivalent) was 3,489. The molecular weight of this polymer was measured by GPC (standard polystyrene equivalent), the weight average molecular weight (Mw) was 1,218, and the polymer had a repeating unit structure of the following Formula (6).

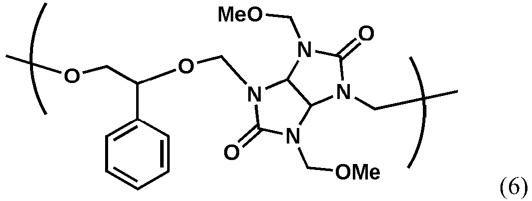

### <Comparative Synthesis Example 2> Synthesis of polymer (S2) (PL-LI/1,4-butanediol = 100/100)

5.00 g (15.71 mmol) of tetramethoxymethyl glycoluril (POWDERLINK1174, commercially available from Mitsui Cytec Ltd.), 1.41 g (15.71 mmol) of 1,4-butanediol (commercially available from Tokyo Chemical Industry Co., Ltd.), 1.49 g (7.85 mmol) of para-toluenesulfonic acid monohydrate (commercially available from Tokyo Chemical Industry Co., Ltd.), and 24.17 g of propylene glycol monomethyl ether acetate were put into a 100 mL three-neck flask including a stirring bar and a cooling pipe, the temperature was raised to 85°C, and the mixture was stirred at 70°C for 5 hours. After the reaction was stopped, a cation exchange resin and an anion exchange resin in same amounts as the solid content were added respectively to the obtained reaction solution, and the mixture was stirred for 4 hours. The ion exchange resin was filtered to obtain a polymer solution. The molecular weight of this polymer was measured by GPC (standard polystyrene equivalent), the weight average molecular weight (Mw) was 995, and the polymer had a repeating unit structure of the following Formula (7).

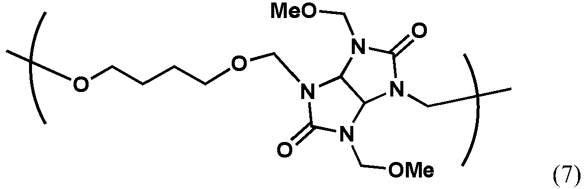

### <Preparation of resist underlayer film>

Polymers (1) to (3) and (S1) and (S2), a crosslinking agent [tetramethoxymethyl glycoluril], an acid catalyst [p-toluenesulfonic acid], a solvent [propylene glycol monomethyl ether acetate (PGMEA), propylene glycol monomethyl ether (PGME)], and Megaface R-40 (commercially available from DIC) as a surfactant were mixed in weight proportions (weight proportions of the crosslinking agent, the acid generating agent and the surfactant when the weight of the polymer was set to 100; for solvents, the weight proportion of each solvent when the total weight of the solvents was set to 100) shown in the following Table 4, the mixtures were filtered through a 0.1 µm polytetrafluoroethylene microfilter to prepare resist underlayer film materials (Examples 1 to 3, and Comparative Example 1 and Comparative Example 2).

### [Measurement of hardness]

The resist underlayer film-forming compositions prepared in Example 1 to Example 3, and Comparative Examples 1 and 2 were each applied onto a silicon wafer by a spinner. Then, baking was performed on a hot plate at 400°C for 90 seconds to form a resist underlayer film (with a film thickness of 0.2 µm). A nanoindentation test with a nanoindenter (commercially available from Toyo Corporation) was performed, and the hardness of the resist underlayer film was measured. The results are shown in Table 1. The resist underlayer films formed from the resist underlayer film-forming compositions prepared in Example 1 to Example 3 had higher hardness than the resist underlayer films formed from the resist underlayer film-forming compositions prepared in Comparative Examples 1 and 2.

**[Table 1]**

| | Hardness (GPa) |
|---|---|
| Example 1 | 1.07 |
| Example 2 | 0.91 |
| Example 3 | 0.76 |
| Comparative Example 1 | 0.46 |
| Comparative Example 2 | 0.42 |

### [Measurement of film density]

The resist underlayer film-forming compositions prepared in Example 1 to Example 3, and Comparative Examples 1 and 2 were each applied onto a silicon wafer by a spinner. Then, baking was performed on a hot plate at 400°C for 90 seconds to form a resist underlayer film (with a film thickness of 0.2 µm). XRR measurement was performed using D8 DISCOVER (commercially available from Bruker AXS), and the film density of the resist underlayer film was measured. The results are shown in Table 2. The resist underlayer films formed from the resist underlayer film-forming compositions prepared in Example 1 to Example 3 had higher film density than the resist underlayer films formed from the resist underlayer film-forming compositions prepared in Comparative Examples 1 and 2.

**[Table 2]**

| | Film density (g/cm³) |
|---|---|
| Example 1 | 1.51 |
| Example 2 | 1.37 |
| Example 3 | 1.28 |
| Comparative Example 1 | 1.19 |
| Comparative Example 2 | 1.18 |

## Claims

1. A resist underlayer film-forming composition comprising a polymer obtained by reacting a glycoluril compound with an aromatic compound having at least one phenolic hydroxyl group and a solvent, wherein a nitrogen content of the polymer is less than 10% by mass.

2. The resist underlayer film-forming composition according to claim 1, wherein a carbon content of the polymer is 80% or less.

3. The resist underlayer film-forming composition according to claim 1, wherein the glycoluril compound is a glycoluril compound substituted with at least one substituent, and the substituent is at least one substituent selected from the group consisting of a C₁₋₁₂ alkylol group, a C₂₋₁₂ alkoxyalkyl group, and a C₃₋₁₂ alkenyloxyalkyl group.

4. The resist underlayer film-forming composition according to claim 1, wherein the glycoluril compound is selected from the group consisting of tetramethylol glycoluril, tetrabutoxymethyl glycoluril, tetramethoxymethyl glycoluril, partially methylolated glycoluril, dimethoxymethyl glycoluril, monomethyl ether of dimethylol glycoluril or dimethyl ether of dimethylol glycoluril, trimethyl ether of tetramethylol glycoluril, tetramethyl ether of tetramethylol glycoluril, tetraethoxymethyl glycoluril, tetrapropoxymethyl glycoluril, tetraamyloxymethyl glycoluril, tetrahexoxymethyl glycoluril, and mixtures thereof.

5. The resist underlayer film-forming composition according to claim 1, wherein the glycoluril compound is a glycoluril compound substituted with at least a methoxymethyl group.

6. The resist underlayer film-forming composition according to claim 1, wherein the aromatic compound having a phenolic hydroxyl group is selected from among the following compounds:

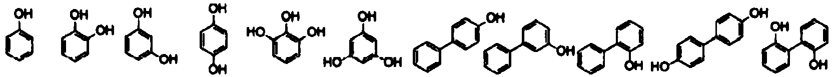

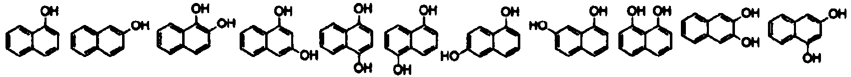

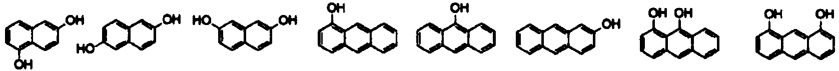

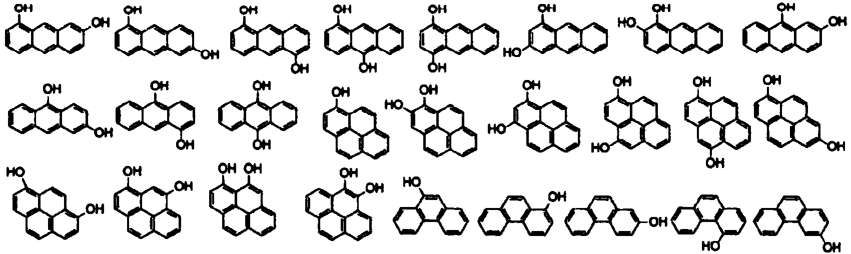

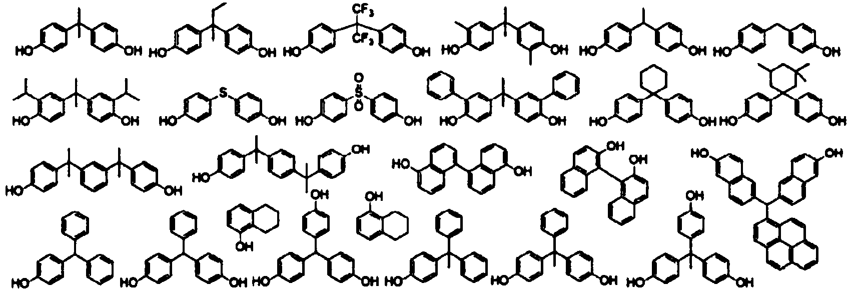

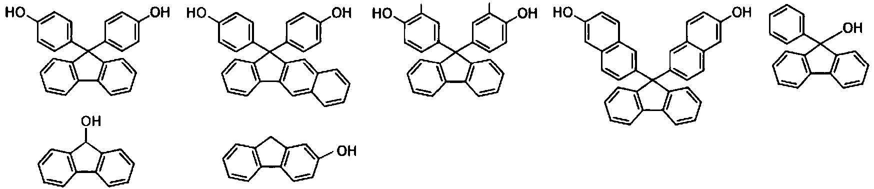

7. The resist underlayer film-forming composition according to claim 1, wherein the solvent is a solvent having a boiling point of 160°C or higher.

8. The resist underlayer film-forming composition according to claim 1, further comprising a crosslinking agent.

9. The resist underlayer film-forming composition according to claim 8, wherein the crosslinking agent is an aminoplast crosslinking agent, or an aminoplast crosslinking agent and a phenoplast crosslinking agent.

10. The resist underlayer film-forming composition according to claim 1, further comprising a surfactant.

11. The resist underlayer film-forming composition according to claim 1, further comprising an acid and/or salts of the acid and/or an acid generating agent.

12. A resist underlayer film which is a baked product of a coating film formed of the composition according to any one of claims 1 to 11.

13. A method of forming a resist pattern used in production of semiconductors, comprising:
a step of applying the resist underlayer film-forming composition according to any one of claims 1 to 11 onto a semiconductor substrate and baking to form a resist underlayer film;
a step of forming a resist film on the resist underlayer film; and
a step of forming a resist pattern on the resist film by emitting light or an electron beam and developing.

14. A method of producing a semiconductor device, comprising:
a step of applying the resist underlayer film-forming composition according to any one of claims 1 to 11 onto a semiconductor substrate and baking to form a resist underlayer film;
a step of forming a resist film on the resist underlayer film;
a step of forming a resist pattern on the resist film;
a step of etching the resist underlayer film using the resist pattern; and
a step of processing the semiconductor substrate using the patterned resist underlayer film.

15. The method of producing a semiconductor device according to claim 14, wherein the resist pattern is formed on the resist film by emitting light or an electron beam and developing.

16. The method of producing a semiconductor device according to claim 14, wherein the resist pattern is formed on the resist film by a nanoimprinting method or a self-assembled film.

17. A method of producing a semiconductor device, comprising:
a step of applying the resist underlayer film-forming composition according to any one of claims 1 to 11 onto a semiconductor substrate and baking to form a resist underlayer film;
a step of forming a hard mask on the resist underlayer film;
a step of additionally forming a resist film on the hard mask;
a step of forming a resist pattern on the resist film;
a step of etching the hard mask using the resist pattern;
a step of etching the resist underlayer film using the patterned hard mask; and
a step of processing the semiconductor substrate using the patterned resist underlayer film.

18. The method of producing a semiconductor device according to claim 17, wherein the hard mask is formed by applying a composition containing an inorganic substance or depositing a composition containing an inorganic substance.

19. The method of producing a semiconductor device according to claim 17, wherein the resist pattern is formed on the resist film by emitting light or an electron beam and developing.

20. The method of producing a semiconductor device according to claim 17, wherein the resist pattern is formed on the resist film by a nanoimprinting method or a self-assembled film.

21. A method of producing a semiconductor device, comprising:
a step of applying the resist underlayer film-forming composition according to any one of claims 1 to 11 onto a semiconductor substrate and baking to form a resist underlayer film;
a step of forming a hard mask on the resist underlayer film;
a step of additionally forming a resist film on the hard mask;
a step of forming a resist pattern on the resist film;
a step of etching the hard mask using the resist pattern;
a step of etching the resist underlayer film using the patterned hard mask;
a step of removing the hard mask; and
a step of processing the semiconductor substrate using the patterned resist underlayer film.

22. The method of producing a semiconductor device according to claim 21, wherein the hard mask is formed by applying a composition containing an inorganic substance or depositing a composition containing an inorganic substance.

23. The method of producing a semiconductor device according to claim 21, wherein the resist pattern is formed on the resist film by emitting light or an electron beam and developing.

24. The method of producing a semiconductor device according to claim 21, wherein the resist pattern is formed on the resist film by a nanoimprinting method or a self-assembled film.

25. The method of producing a semiconductor device according to claim 21, wherein the hard mask is removed by etching or using an alkaline chemical solution.

26. A method of producing a semiconductor device, comprising:
a step of applying the resist underlayer film-forming composition according to any one of claims 1 to 11 onto a semiconductor substrate and baking to form a resist underlayer film;
a step of forming a hard mask on the resist underlayer film;
a step of additionally forming a resist film on the hard mask;
a step of forming a resist pattern on the resist film;
a step of etching the hard mask using the resist pattern;
a step of etching the resist underlayer film using the patterned hard mask;
a step of removing the hard mask;
a step of forming a vapor-deposited film (spacer) on the resist underlayer film after the hard mask is removed;
a step of processing the vapor-deposited film (spacer) by etching;
a step of removing the patterned resist underlayer film such that the patterned vapor-deposited film (spacer) remains; and
a step of processing the semiconductor substrate using the patterned vapor-deposited film (spacer).

27. The method of producing a semiconductor device according to claim 26, wherein the hard mask is formed by applying a composition containing an inorganic substance or depositing a composition containing an inorganic substance.

28. The method of producing a semiconductor device according to claim 26, wherein the resist pattern is formed on the resist film by emitting light or an electron beam and developing.

29. The method of producing a semiconductor device according to claim 26, wherein the resist pattern is formed on the resist film by a nanoimprinting method or a self-assembled film.

30. The method of producing a semiconductor device according to claim 26, wherein the hard mask is removed by etching or using an alkaline chemical solution.
